(19) Europäisches Patentamt

European Patent Office

Office européen des brevets

(11)     EP 1 306 159 B1

(12)     **EUROPÄISCHE PATENTSCHRIFT**

(45) Veröffentlichungstag und Bekanntmachung des Hinweises auf die Patenterteilung:
**10.08.2005   Patentblatt 2005/32**

(51) Int Cl.⁷: **B23K 20/10**

(21) Anmeldenummer: **01204143.0**

(22) Anmeldetag: **26.10.2001**

(54) **Verfahren für die Kalibrierung eines Wire Bonders**

Calibration method for a wire bonder

Méthode de calibration d'un dispositif de microcablage

(84) Benannte Vertragsstaaten:
DE

(43) Veröffentlichungstag der Anmeldung:
**02.05.2003   Patentblatt 2003/18**

(73) Patentinhaber: **Unaxis International Trading Ltd
6330 Cham (CH)**

(72) Erfinder:
• **Mayer, Michael
6345 Neuheim (CH)**

• **Schwizer, Jürg
6264 Pfaffnau (CH)**

(74) Vertreter: **Falk, Urs, Dr. et al
Patentanwaltsbüro Dr. Urs Falk,
Eichholzweg 9A
6312 Steinhausen (CH)**

(56) Entgegenhaltungen:
**EP-A- 0 498 936          EP-A- 0 953 398
US-A- 5 357 423**

• **XP001069168**

**Beschreibung**

Die Erfindung betrifft ein Verfahren für die Kalibrierung eines Wire Bonders.

Ein Wire Bonder ist eine Maschine, mit der Halbleiterchips nach deren Montage auf einem Substrat verdrahtet werden. Der Wire Bonder weist eine Kapillare auf, die an der Spitze eines Horns eingespannt ist. Die Kapillare dient zum Befestigen des Drahtes auf einem Anschlusspunkt des Halbleiterchips und auf einem Anschlusspunkt des Substrates sowie zur Drahtführung zwischen den beiden Anschlusspunkten. Bei der Herstellung der Drahtverbindung zwischen dem Anschlusspunkt des Halbleiterchips und dem Anschlusspunkt des Substrates wird das aus der Kapillare ragende Drahtende zunächst zu einer Kugel geschmolzen. Anschliessend wird die Drahtkugel auf dem Anschlusspunkt des Halbleiterchips mittels Druck und Ultraschall befestigt. Dabei wird das Horn von einem Ultraschallgeber mit Ultraschall beaufschlagt. Diesen Prozess nennt man Ball-bonden. Dann wird der Draht auf die benötigte Drahtlänge durchgezogen, zu einer Drahtbrücke geformt und auf dem Anschlusspunkt des Substrates verschweisst. Diesen letzten Prozessteil nennt man Wedge-bonden. Nach dem Befestigen des Drahtes auf dem Anschlusspunkt des Substrats wird der Draht abgerissen und der nächste Bondzyklus kann beginnen.

Das Ball-bonden wird von verschiedenen Faktoren beeinflusst. Um Bondverbindungen von vorbestimmter Qualität zu erzielen, müssen für einen bestimmten Prozess die optimalen Werte mehrerer physikalischer und/oder technischer Parameter eruiert werden. Beispiele solcher Parameter sind die Bondkraft, das ist die Kraft, die die Kapillare während des Bondvorganges auf den Ball bzw. den Anschlusspunkt des Halbleiterchips ausübt, oder die Amplitude des Wechselstroms, mit dem der Ultraschallgeber des Horns beaufschlagt wird.

Beim Bonden nützt sich die Kapillare ab, so dass sie von Zeit zu Zeit durch eine neue Kapillare ersetzt werden muss. Beim Kapillarenwechsel ändert sich in der Regel das Schwingungsverhalten der Kapillarenspitze, weil jede Kapillare etwas andere Eigenschaften aufweist und auch etwas anders im Horn eingespannt ist. Nach jedem Kapillarenwechsel müssen daher bestimmte Parameter des Wire Bonders neu kalibriert werden, insbesondere muss die Amplitude des Wechselstroms, mit dem der Ultraschallgeber des Horns beaufschlagt wird, den neuen Verhältnissen angepasst werden.

Aus dem europäischen Patent EP 498 936 ist ein Verfahren für die Kalibrierung der Schwingungsamplitude des Horns bekannt. Bei diesem Verfahren wird die Amplitude der in der Luft frei schwingenden Hornspitze gemessen und die Amplitude des Wechselstroms, mit dem der Ultraschallgeber des Horns beaufschlagt wird, neu so bestimmt, dass die Amplitude der in der Luft frei schwingenden Hornspitze einen vorbestimmten Wert annimmt.

Aus der europäischen Patentanmeldung EP 953 398 ist ein Verfahren für die Kalibrierung von Parametern eines Wire Bonders bekannt, bei dem die Spitze der Kapillare oder die von der Spitze der Kapillare geführte Bondkugel einen Anschlusspunkt auf einem Tesichip berührt. Der Testchip enthält einen im Bereich des Anschlusspunktes integrierten Sensor, dessen Signal für die Kalibrierung benutzt wird. Für die Kalibrierung der Ultraschallleistung ist beispielsweise ein die Temperatur messender Sensor vorgesehen.

Aus dem Artikel "Analysis of ultrasonic wire bonding by in-situ piezoresistive microsensors", der in den Proceedings der vom 10.-14. Juni 2001 in München durchgeführten Konferenz "Transducers '0 1 Eurosensors XV" veröffentlicht wurde, ist ein piezoresistiver Sensor bekannt, mit dem sich die beim Bonden im Silizium auftretenden mechanischen Spannungen erfassen lassen.

Der Erfindung liegt die Aufgabe zugrunde, ein Verfahren für die Kalibrierung eines Wire Bonders zu entwickeln, das gewährleistet, dass Halbleiterchips in der Massenproduktion vor und nach einem Kapillarenwechsel unter den gleichen Prozessbedingungen verdrahtet werden.

Eine weitere Aufgabe, die sich in der Massenproduktion stellt, ist die Übertragung der auf einem Wire Bonder gefundenen optimalen Parameter auf einen anderen Wire Bonder. Die Erfindung soll auch für diese Aufgabe eine Lösung bieten und den Rezepttransfer von Wire Bonder zu Wire Bonder auf einfache und robuste Weise unterstützen.

Die genannten Aufgaben werden erfindungsgemäss gelöst durch ein Verfahren, bei dem zunächst bei einem ersten Wire Bonder mittels eines in einem Halbleiterchip integrierten Sensors eine Referenzgrösse bestimmt wird und bei dem der gleiche Sensor oder ein Sensor des gleichen Typs benutzt wird, um den ersten Wire Bonder erneut, z.B. nach einem Kapillarenwechsel, oder einen anderen Wire Bonder mit Bezug auf diese Referenzgrösse zu kalibrieren.

Jeder Wire Bonder weist eine an einem Horn eingespannte Kapillare auf. Ein Ultraschallgeber beaufschlagt das Horn mit Ultraschall, wobei der Ultraschallgeber mittels eines Parameters P gesteuert wird. Für die Kalibrierung des Parameters P wird eine Referenzgrösse $U_{Ref}$ gemäss den folgenden Schritten bestimmt:

  a1) Aufsetzen der Kapillare ohne Draht bzw. ohne Drahtkugel auf einen Kontaktbereich des Sensors,
  b1) Beaufschlagung der Kapillare mit einer Bondkraft $F_C$, die so gross ist, dass die Kapillare beim nächsten Schritt auf der Oberfläche des Sensors 1 nicht hin und her rutscht,
  c1) Beaufschlagung des Ultraschallgebers mit einem vorbestimmten Wert $P_1$ des Parameters und Erfassung des Wertes $U_1$ der Amplitude des Sensorsignals, nachdem sich ein stationärer Zustand eingestellt hat, und
d 1) Speicherung des Wertes $U_1$ des Sensorsignals als Referenzgrösse $U_{Ref}$.

Der erste Wire Bonder wird dann, z.B. nach einem Kapillarenwechsel, neu kalibriert oder ein anderer Wire Bonder wird kalibriert, indem ein Korrekturfaktor $\gamma$ gemäss den folgenden Schritten bestimmt wird:

a2) Aufsetzen der Kapillare ohne Draht bzw. ohne Drahtkugel auf den Kontaktbereich des gleichen Sensors oder eines anderen Sensors des gleichen Typs,
b2) Beaufschlagung der Kapillare mit der Bondkraft $F_C$, und
c2) Beaufschlagung des Ultraschallgebers, und
d2) Bestimmung des Korrekturfaktors $\gamma$ so, dass die Amplitude des Sensorsignals den Wert $U_{Ref}$ annimmt, wenn der Ultraschallgeber mit dem Wert $P_2 = \gamma * P_1$ betrieben wird.

Wenn also im Produktionsbetrieb der Ultraschallgeber des derart kalibrierten Wire Bonders mit dem Wert $P_2 = \gamma * P_1$ des Parameters P betrieben wird, dann ist sichergestellt, dass die Halbleiterchips unter den gleichen physikalischen Prozessbedingungen verdrahtet werden wie die Halbleiterchips des ersten Wire Bonders unmittelbar nach der Bestimmung der Referenzgrösse $U_{Ref}$.

Gemäss einem bevorzugten Ausführungsbeispiel wird im Schritt c2) der Ultraschallgeber mit dem Wert $P_1$ des Parameters beaufschlagt und der Wert U der Amplitude des Sensorsignals erfasst, nachdem sich ein stationärer Zustand eingestellt hat, und im Schritt d2) der Korrekturfaktor $\gamma$ bestimmt zu $\gamma = U_{Ref}/U$.

Gemäss einem anderen Ausführungsbeispiel wird im Schritt c2) der Wert des Parameters P verändert, bis die Amplitude des Sensorsignals den Wert $U_{Ref}$ annimmt, wobei der Wert des Parameters P in diesem Zustand mit $P_2$ bezeichnet wird. Der Korrekturfaktor $\gamma$ wird dann bestimmt zu $\gamma = P_2/P_1$.

Der Parameter P. der auf diese Weise kalibriert wird, ist beispielsweise der durch den Ultraschallgeber fliessende Strom oder die an den Ultraschallgeber angelegte Spannung.

Nachfolgend werden Ausführungsbeispiele der Erfindung anhand der Zeichnung näher erläutert.

Es zeigen:

Fig. 1, 2    einen in einem Halbleiterchip integrierten Sensor, der aus vier piezoresistiven Elementen besteht,
Fig. 3    die elektrische Beschaltung der vier piezoresistiven Elemente,
Fig. 4    Teile eines Wire Bonders,
Fig. 5    Ausgangssignale des Sensors, und
Fig. 6    einen weiteren Sensor.

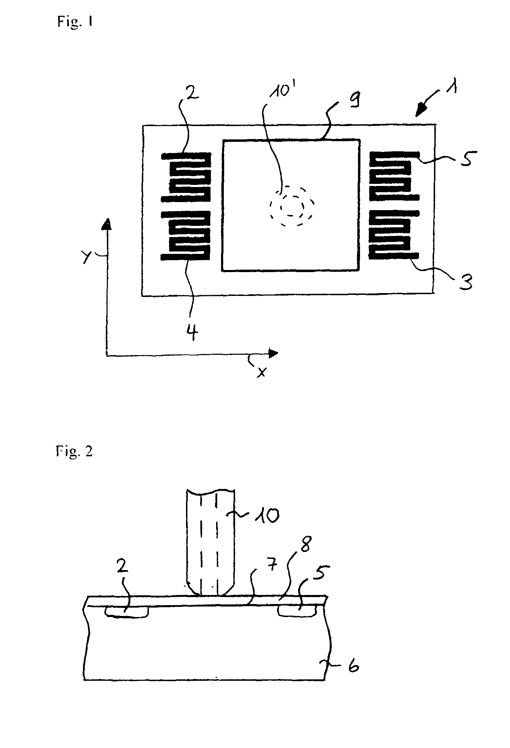

Die Fig. 1 und 2 zeigen in der Aufsicht bzw. im Querschnitt einen in einem Halbleiterchip integrierten Sensor 1, der aus vier piezoresistiven Elementen 2 bis 5 besteht, die elektrisch zu einer Wheatstone Brücke geschaltet sind. Das Ausgangssignal des Sensors 1 entspricht dem Ausgangssignal der Wheatstone Brücke. Der Sensor 1 besteht vorzugsweise aus n-dotiertem Silizium 6, in dessen einer Oberfläche 7 die piezoresistiven Elemente 2 bis 5 als mäanderförmige Widerstandsbahnen aus p-dotiertem Silizium eingebettet sind. Die Oberfläche 7 des Sensors 1 ist mit einer herkömmlichen Passivierungsschicht 8 bedeckt. Die piezoresistiven Elemente 2 bis 5 sind ausserhalb eines etwa quadratischen Kontaktbereiches 9 angeordnet, innerhalb dem die Spitze der Kapillare 10 eines Wire Bonders bei der Kalibrierung der Ultraschallleistung auf den Halbleiterchip drückt. Der Bereich, wo die Spitze der Kapillare 10 im Idealfall auf den Sensor 1 drückt, ist mit einem gestrichelten kreisförmigen Ring 10' dargestellt. In der Fig. 1 sind die Achsen eines kartesischen Koordinatensystems mit x und y bezeichnet. Die x-Richtung verläuft vorzugsweise parallel zu einer [110] Achse des Siliziumkristalls. Die mäanderförmigen Bahnen der piezoresistiven Elemente 2 bis 5 verlaufen in x-Richtung und sind, in x-Richtung gesehen, links und rechts ausserhalb des Kontaktbereiches 9 angeordnet. Sie dienen zur Erfassung von mechanischen Spannungen, die von der Scherkraft $F_x$ verursacht werden, die von der Kapillare 10 bei Beaufschlagung mit Ultraschall im Sensor 1 in x-Richtung induziert wird. Bei der Kalibrierung ist der Sensor 1 bezüglich des Wire Bonders so zu orientieren, dass die Schwingungsrichtung der Kapillare 10 möglichst parallel zur x-Richtung verläuft.

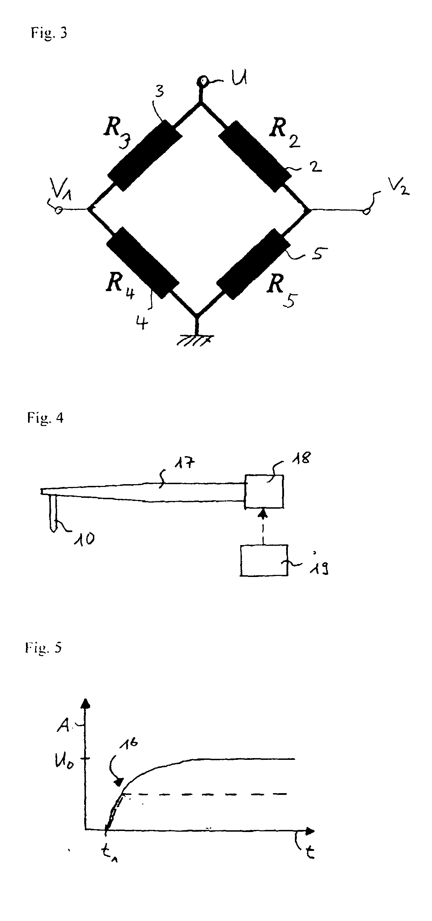

Die Fig. 3 zeigt das elektrische Schaltbild der aus den vier piezoresistiven Elementen 2 bis 5 gebildeten Wheatstone Brücke. Die vier piezoresistiven Elemente 2 bis 5 sind über gewöhnliche Leiterbahnen aus Aluminium verdrahtet. Die Wheatstone Brücke wird vorzugsweise aus einer Konstantspannungsquelle mit einer Spannung U gespeist. Die Ausgangsspannung $U_{Out} = V_1 - V_2$ der Wheatstone Brücke ergibt sich dann zu

$$U_{Out} = \frac{R_2 R_4 - R_3 R_5}{(R_3 + R_4)*(R_2 + R_5)} U \qquad (1),$$

wobei $R_2$ bis $R_5$ die ohmschen Widerstände der piezoresistiven Elemente 2 bis 5 bezeichnen.

Der Sensor 1 eignet sich für die Kalibrierung des Ultraschallgebers des Wire Bonders bzw. genauer eines Parameters P, mit dem der Ultraschallgeber gesteuert wird. Die Fig. 4 zeigt schematisch Teile eines Wire Bonders, nämlich ein Horn 17, einen aus Piezoelementen gebildeten Ultraschallgeber 18 und eine den Ultraschallgeber 18 speisende Energiequelle 19. Bei der Verdrahtung eines Halbleiterchips mittels eines Wire Bonders gemäss den in der Einleitung beschriebenen Verfahrensschritten müssen für ein spezifisches Produkt, d.h. eine spezifische Kombination von Halbleiterchip und Substrat, diverse Bondparameter optimiert werden. In der Literatur, auch in der Patentliteratur, sind unzählige Details des Ball-bondens ausführlich beschrieben worden. Für das Verständnis der Erfindung wird das folgende einfache Beispiel eines Ballbondprozesses benützt. Nach dem Formen der Drahtkugel an der Spitze der Kapillare wird die Kapillare abgesenkt, bis die Drahtkugel auf dem Anschlusspunkt des Halbleiterchips auftrifft und bis die Kapillare die Drahtkugel mit einer vorbestimmten Kraft, der sogenannten Bondkraft $F_B$, auf den Anschlusspunkt presst. Dann wird die Kapillare während einer vorbestimmten Bondzeit $\tau$ mit Ultraschall beaufschlagt. Anschliessend wird die Kapillare wieder angehoben und die Drahtbrücke geformt. Die Kapillare ist an der Spitze des Horns 17 eingespannt. Das Horn 17 wird während des Bondens mittels des Ultraschallgebers 18 mit Ultraschall beaufschlagt. Der Ultraschallgeber 18 wird dabei von der Energiequelle 19 mit einem konstanten Wechselstrom oder einer konstanten Wechselspannung oder einer konstanten Leistung beaufschlagt. Im Beispiel wird der Ultraschallgeber 18 mit einem Wechselstrom $I=I_T * \sin(\omega t)$ beaufschlagt, wobei $I_T$ die Amplitude, $\omega$ die Frequenz und t die Zeit bezeichnen. Im Beispiel ist also der Parameter P, mit dem der Ultraschallgeber 18 beaufschlagt wird, der von der Energiequelle 19 gelieferte Wechselstrom I.

Bevor die Verdrahtung eines neuen Produktes beginnt, müssen zunächst die dem Produkt angepassten, geeigneten Parameter für die Bondkraft $F_B$, für die Amplitude $I_1$ des Wechselstroms und die Bondzeit $\tau$ ermittelt werden. Die Bestimmung dieser Parameter erfolgt mit einer ersten Kapillare und die gefundenen optimalen Werte der Parameter werden mit $F_{B1}$, $I_{T1}$ und r bezeichnet. Nachdem diese Parameter ermittelt wurden, wird eine Referenzgrösse $U_{Ref}$ gemäss den folgenden Schritten bestimmt:

1. Die Kapillare wird, ohne Draht bzw. ohne Drahtkugel, auf den Kontaktbereich 9 des Sensors 1 aufgesetzt. Die Kapillare soll möglichst in der Mitte des Kontaktbereiches 9 aufgesetzt werden.
2. Die Kapillare wird mit einer Bondkraft $F_C$ beaufschlagt, die so gross ist, dass die Kapillare beim nächsten Schritt 3 auf der Oberfläche des Sensors 1 nicht hin und her rutscht. Bewährt hat sich eine Bondkraft von 1N.
3. Der Ultraschallgeber wird mit einem konstanten Wechselstrom, dessen Amplitude den Wert $I_{T1}$ hat, beaufschlagt. Dann wird gewartet, bis der Einschwingvorgang abgeschlossen und ein stationärer Zustand erreicht ist. Dieser stationäre Zustand ist dadurch charakterisiert, dass die Amplitude $U_0$ des Sensorsignals $U_{Out}(t)$ nicht mehr ändert.
4. Die im stationären Zustand auftretende Amplitude $U_0$ des Sensorsignals $U_{Out}(t)$ wird als Referenzgrösse $U_{Ref}$ gespeichert: $U_{Ref} = U_0$ (2).

Anschliessend wird der Draht wieder in die Kapillare eingefädelt und die Produktion mit den vorgängig gefundenen Werten $F_{B1}$ für die Bondkraft, $I_{T1}$ für die Amplitude des durch den Ultraschallgeber fliessenden Wechselstroms und der Bondzeit $\tau$ gestartet.

Nach einem Wechsel der Kapillare oder einem Wechsel des Horns oder auch für eine Nacheichung während der Produktion wird jeweils ein neuer Wert $I_{T2}$ für die Amplitude $I_T$ des durch den Ultraschallgeber fliessenden Wechselstroms bestimmt. Dies kann beispielsweise erfolgen, indem ein Korrekturfaktor $\gamma$ gemäss den folgenden Schritten bestimmt wird:

1. Die neue Kapillare wird wiederum ohne Draht bzw. ohne Drahtkugel und möglichst in der Mitte auf den Kontaktbereich 9 des Sensors 1 aufgesetzt.
2. Die Kapillare wird mit der Bondkraft $F_C$ beaufschlagt.
3. Der Ultraschallgeber wird mit einem konstanten Wechselstrom, dessen Amplitude den Wert $I_{T1}$ hat, beaufschlagt. Dann wird gewartet, bis der Einschwingvorgang abgeschlossen und ein stationärer Zustand erreicht ist. Die im stationären Zustand auftretende Amplitude des Sensorsignals $U_{Out}(t)$ wird als Wert U erfasst.
4. Der Korrekturfaktor $\gamma$ wird bestimmt zu $\gamma = U_{Ref}/U$.

Anschliessend kann die Produktion wieder aufgenommen werden, wobei der Ultraschallgeber mit einem konstanten Wechselstrom beaufschlagt wird, dessen Amplitude gegeben ist durch $I_{T2} = y * I_{f1}$.

Das gleiche Verfahren eignet sich auch für den Parametertransfer vom Referenz Wire Bonder zu einem anderen Wire Bonder. Auf dem anderen Wire Bonder werden die Parameter $U_{Ref}$ und $I_{T1}$ des Referenz Wire Bonders als Keferenzwerte sowie weitere Prozessparameter wie z.B. die Bondkraft gespeichert. Anschliessend wird mittels einer Kalibrierung gemäss den oben beschriebenen Schritten der Korrekturfaktor $\gamma$ bestimmt. Nun kann die Produktion erfolgen, wobei der Ultraschallgeber mit einem konstanten Wechselstrom beaufschlagt wird, dessen Amplitude gegeben ist durch $I_{T2} = \gamma * I_{T1}$.

Der entschcidende Punkt des erfindungsgemässen Verfahrens ist, dass die Kapillare 10 während der Kalibrierung auf dem Sensor 1 nicht hin und her rutscht. Trotzdem übt die Kapillare 10 bei Beaufschlagung mit Ultraschall eine Scherkraft auf den Sensor 1 aus, die von den piezoresistiven Elementen 2 bis in ein elektrisches Signal umgeformt wird. Die Fig. 5 zeigt die Amplitude A (Absolutbetrag der Umhüllenden) des oszillierenden Ausgangssignals $U_{Out}(t)$ der Wheatstone Brücke in Funktion der Zeit t mit einer ausgezogenen Linie für den Fall, dass die Kapillare 10 nicht rutscht, und mit einer gestrichelten Linie für den Fall, dass die Kapillare 10 plötzlich zu rutschen beginnt. Der Ultraschallgeber wird zum Zeitpunkt $t_1$ mit Ultraschall beauf-

schlagt. Die Kapillare beginnt zu schwingen und ihre Schwingungsamplitude nimmt kontinuierlich zu. Wenn die Kapillare nicht rutscht, dann steigt die Amplitude A während des Einschwingvorganges kontinuierlich an, bis der Einschwingvorgang abgeschlossen ist. Jetzt weist die Amplitude A den konstanten Wert $U_0$ auf. Wenn die Bondkraft bezogen auf die Ultraschallamplitude hingegen zu klein ist, dann beginnt die Kapillare 10 plötzlich zu rutschen: Die im Sensor 1 induzierte Scherkraft $F_x$ nimmt nicht mehr weiter zu. Der Verlauf der Amplitude A weist einen Knick 16 auf, weil die Amplitude A (gestrichelte Linie) auf einem konstanten Niveau verharrt, bevor der Einschwingvorgang abgeschlossen ist.

Der derart bestimmte Wert $U_0$ des Ausganigssignals $U_{Out}$ der Wheatstone Brücke ist sehr linear bezüglich der Amplitude $I_1$ des Wechselstroms, mit dem der Ultraschallgeber beaufschlagt wird. Auch die Temperaturabhängigkeit ist sehr gering und es genügt, wenn die Temperatur während den verschiedenen Kalibrierungsvorgängen auf etwa $\pm\,5°$ C konstant gehalten wird. Zudem kann die Kalibrierung bei der Temperatur erfolgen, bei der in der Produktion gebondet wird. Dies hat den Vorteil, dass beim Kapillarenwechsel keine wertvolle Zeit verloren geht, weil der Wire Bonder nicht abgekühlt und dann wieder auf die Prozesstemperatur erwärmt werden muss.

Da zudem die Unterschiede von Sensor zu Sensor genügend gering sind, muss nicht immer der gleiche Sensor verwendet werden. Dies erlaubt den Rezepttransfer auch dann, wenn auf jedem Wire Bonder ein Sensor fest installiert ist.

Es sei hier erwähnt, dass für die Nacheichung des Parameters P, im Beispiel also der Amplitude des durch den Ultraschallgeber fliessenden Wechselstroms, auch ein etwas abgeändertes Verfahren verwendet werden kann, bei dem direkt die Amplitude $I_{T2}$ des durch den Ultraschallgeber fliessenden Wechselstroms neu bestimmt wird. Dabei werden zuerst die Schritte a2 und b2 des vorgängigen Verfahrens durchgeführt. Anschliessend wird im Schritt c2 der Ultraschallgeber mit einem konstanten Wechselstrom beaufschlagt, dessen Amplitude den Wert $I_{T1}$ hat. Dann wird gewartet, bis der Einschwingvorgang abgeschlossen und ein stationärer Zustand erreicht ist. Nun wird im Schritt d2 die Amplitude $I_{T1}$ solange verändert, bis die Amplitude des Sensorsignals $U_{Out}(t)$ den Wert $U_{Ref}$ hat. Der zugehörige Wert der Amplitude $I_{T2}$ wird gespeichert. Der Korrekturfaktor $\gamma$ ergibt sich dann zu $\gamma = I_{T2}/I_{T1}$.

Anschliessend kann die Produktion wieder aufgenommen werden, wobei der Ultraschallgeber mit einem konstanten Wechselstrom beaufschlagt wird, dessen Amplitude gegeben ist durch den neu ermittelten Wert $I_{T2}$, wobei gilt $I_{T2} = \gamma * I_{T1}$.

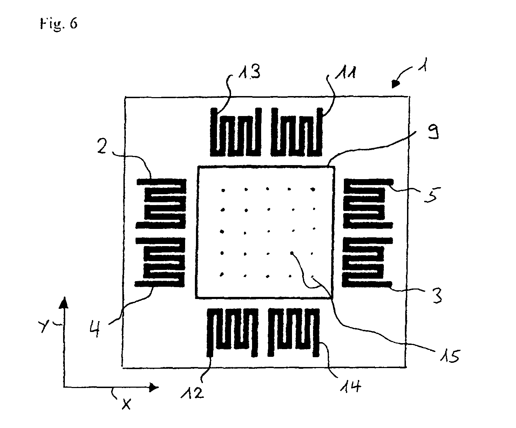

Die Fig. 6 zeigt in Aufsicht einen Sensor 1, der die vier piezoresistiven Elemente 2 bis 5 enthält für die Messung der in x-Richtung induzierten Scherkraft $F_x$, und der vier weitere piezoresistiveElemente 11 bis 14 enthält für die Messung der in y-Richtung induzierten Scherkraft $F_y$. Die vier piezoresistiven Elemente 2 bis 5 sind elektrisch zu einer ersten Wheatstone Brücke geschaltet, deren Ausgangssignal mit $U_{Out.x}(t)$ bezeichnet wird. Die vier piezoresistiven Elemente 11 bis 14 sind elektrisch zu einer zweiten Wheatstone Brücke geschaltet, deren Ausgangssignal mit $U_{Out.s}(t)$ bezeichnet wird. Mit diesem Sensor 1 lässt sich eine Referenzgrösse $U_{Ref}$ bestimmen, ohne dass die Schwingungsrichtung der Kapillare 10 parallel zur x-Richtung des Sensors 1 ausgerichtet werden muss. Sobald der Einschwingvorgang abgeschlossen und ein stationärer Zustand erreicht ist, wird die Referenzgrösse $U_{Ref}$ aus den Amplituden $U_{0.x}$ und $U_{0.s}$ der Ausgangssignale $U_{Out.s}(t)$ und $U_{Out.y}(t)$ bestimmt zu

$$U_{Ref} = \sqrt{U_{0.x}^2 + U_{0.y}^2} \qquad (3).$$

Die Abmessungen des Kontaktbereiches 9 betragen typischerweise $80\mu m \cdot 80\mu m$, während der Durchmesser der Spitze der Kapillare 10 etwa $20\mu m$ bis $30\mu m$ beträgt.

Die Amplituden der Ausgangssignale $U_{Out.x}$ und $U_{Out.y}$ sind abhängig von der Position, wo die Kapillare 10 auf den Kontaktbereich 9 drückt. Zur Erhöhung der Genauigkeit der Kalibrierung wird deshalb vorgeschlagen, die Kapillare 10 an verschiedenen Stellen auf den Kontaktbereich 9 abzusetzen und die Referenzgrösse $U_{Ref}$ und den Korrekturfaktor $\gamma$ aufgrund der an diesen Stellen erhaltenen Messwerte zu bestimmen, z. B. folgendermassen:

In der Fig. 6 sind schematisch die mittleren Aufsetzpunkte 15 der Kapillare 10 gezeigt, denen je ein Koordinatenpaar $(x_{1.k}, y_{1.k})$ zugeordnet ist, wobei die indices i und k im Beispiel je fünf verschiedene Werte annehmen. Der Abstand zwischen zwei Aufsetzpunkten 15 beträgt typisch $5\mu m$ bis $10\mu m$. Die gemäss einem der vorstehend beschriebenen Verfahren gemessenen Amplituden $U_{0,x}(x_{1,k}, y_{i,k})$ und, gegebenenfalls $U_{0,y}(x_{1,k}, y_{i,k})$, formen je eine Fläche mit einem Sattel. Es werden nun die Koordinaten des Sattels $(x_{S,x}, y_{S,x})$ der Funktion $U_{0,x}$ und dann der Wert $U_{0,x}(x_{S,x}, y_{S,x})$ sowie, gegebenenfalls, die Koordinaten des Sattels $(x_{S,y}, y_{S,y})$ der Funktion $U_{0,y}$ und dann der Wert $U_{0,y}(x_{S,y}, y_{S,y})$ rechnerisch bestimmt und schliesslich der Referenzwert $U_{Ref}$ gemäss Gleichung (2) bzw. (3) berechnet.

Falls der Ultraschallgeber nicht mit einem konstanten Wechselstrom, sondern mit einer konstanten Wechselspannung gespeist wird, dann erfolgt die Kalibrierung auf analoge Weise, wobei Ströme durch Spannungen ersetzt werden.

**Patentansprüche**

1.   Verfahren für die Kalibrierung eines oder mehrerer Wire Bonder mittels eines in einem Halbleiterchip integrierten Sensors (1), wobei jeder Wire Bonder eine an einem Horn eingespannte Kapillare (10) aufweist, wobei ein Ultraschallgeber das Horn mit Ultraschall beaufschlagt, wobei der Ultraschallgeber mittels eines Parameters P gesteuert wird und wobei mittels eines ersten Wire Bonders eine Referenzgrösse $U_{Ref}$ gemäss den folgenden Schritten bestimmt wird:

a1) Aufsetzen der Kapillare (10) ohne Draht bzw. ohne Drahtkugel auf einen Kontaktbereich (9) des Sensors (1),

b1) Beaufschlagung der Kapillare (10) mit einer Rondkratt $F_C$, die so gross ist, dass die Kapillare (10) beim nächsten Schritt auf dem Kontaktbereich (9) des Sensors (1) nicht hin und her rutscht,

c1) Beaufschlagung des Ultraschallgebers mit einem vorbestimmten Wert $P_1$ des Parameters und Erfassung des Wertes $U_1$ der Amplitude des Sensorsignals, nachdem sich ein stationärer Zustand eingestellt hat, und

d1) Speicherung des Wertes $U_1$ des Sensorsignals als Referenzgrösse $U_{Ref}$,

und wobei der Parameter P des ersten Wire Bonders, z.B. nach einem Kapillarenwechscl, neu kalibriert oder der Parameter P eines anderen Wire Bonders kalibriert wird, um dessen Ultraschallgeber im Produktionsbetrieb mit einem Wert $P_2 = \gamma * P_1$ des Parameters P zu betreiben, wobei $\gamma$ ein Korrekturfaktor ist, der gemäss den folgenden Schritten bestimmt wird:

a2) Aufsetzen der Kapillare ohne Draht bzw. ohne Drahtkugel auf den Kontaktbereich (9) des gleichen Sensors (1) oder eines anderen Sensors (1) des gleichen Typs,

b2) Beaufschlagung der Kapillare (10) mit der Bondkraft $F_C$, und

c2) Beaufschlagung des Ultraschallgebers, und

d2) Bestimmung des Korrekturfaktors $\gamma$ so, dass die Amplitude des Sellsorsignals den Wert $U_{Ref}$ annimmt, wenn der Ultraschallgeber mit dem Wert $P_2 = \gamma * P_1$ beaufschlagt wird.

2. Verfahren nach Anspruch 1, **dadurch gekennzeichnet, dass** im Schritt c2) der Ultraschallgeber mit dem Wert $P_1$ des Parameters beaufschlagt wird und der Wert U der Amplitude des Sensorsignals erfasst wird, nachdem sich ein stationärer Zustand eingestellt hat, und dass im Schritt d2) der Korrekturfaktor $\gamma$ bestimmt wird zu $\gamma = U_{Ref}/ U$.

3. Verfahren nach Anspruch 1, **dadurch gekennzeichnet, dass** im Schritt c2) der Wert des Parameters P verändert wird, bis die Amplitude des Sensorsignals den Wert $U_{Ref}$ annimmt, und dass der Korrekturfaktor y bestimmt wird zu $\gamma = P_2/P_1$.

4. Verfahren nach einem der Ansprüche 1 bis 3, **dadurch gekennzeichnet, dass** die Kapillare (10) an mehreren Stellen auf dem Kontaktbereich (9) des Sensors (1) abgesetzt wird und dass die Referenzgrösse $U_{Ref}$ und der Korrekturfaktor $\gamma$ aufgrund der an diesen Stellen erhaltenen Messwerte bestimmt wird.

5. Verfahren nach einem der Ansprüche 1 bis 4, **dadurch gekennzeichnet, dass** der Parameter P der durch den Ultraschallgeber fliessende Wechselstrom ist.

6. Verfahren nach einem der Ansprüche 1 bis 5, **dadurch gekennzeichnet, dass** der Sensor (1) piezoresistive Elemente (2, 3, 4, 5) enthält.

7. Verfahren nach Anspruch 6, **dadurch gekennzeichnet, dass** der Sensor (1) erste piezoresistive Elemente (2, 3, 4, 5) für die Messung der in einer ersten Richtung induzierten Scherkraft und zweite piezoresistive Elemente ( 11, 12, 13, 14) für die Messung der in einer zweiten Richtung induzierten Scherkraft enthält und dass die von den ersten piezoresistiven Elementen und die von den zweiten piezoresistiven Elementen gelieferten Signale benutzt werden zur Bestimmung der Referenzgrösse $U_{Ref}$ und des Korrekturfaktors $\gamma$.

**Claims**

1. Method for the calibration of one or several Wire Bonders by means of a sensor (1) integrated into a semiconductor chip, whereby each Wire Bonder has a capillary (10) clamped onto a horn, whereby ultrasonics are applied to the horn by an ultrasonic transducer, whereby the ultrasonic transducer is controlled by means of a parameter P and whereby a reference value $U_{Ref}$ is determined by means of a first Wire Bonder in accordance with the following steps:

a1) Placing the capillary (10) without wire or wire ball onto a contact area (9) of the sensor (1),

b1) Applying a bond force $F_C$ to the capillary (10) which is great enough so that, in the next step, the capillary (10) does not slide back and forth on the contact area (9) of the sensor (1),

c1) Applying a predetermined value $P_1$ of the parameter to the ultrasonic transducer and obtaining the value $U_1$ of the amplitude of the sensor signal once a stationary condition has set in, and

d1) Storing the value $U_1$ of the sensor signal as reference value $U_{Ref}$,

and whereby the parameter P of the first Wire Bonder is recalibrated, for example after changing the capillary, or the parameter P of another Wire Bonder is calibrated in order to operate its ultrasonic transducer in production with a value $P_2 = \square {}^*P_1$ of the parameter P, whereby $\square$ is a correction factor which is determined in accordance with the following steps:

a2) Placing the capillary (10) without wire or wire ball onto the contact area (9) of the same sensor (1) or a different sensor (1) of the same type,

b2) Applying the bond force $F_C$ to the capillary (10), and

c2) Operating the ultrasonic transducer, and

d2) Determining the correction factor $\square$ so that the amplitude of the sensor signal assumes the value $U_{Ref}$ when the value $P_2 = \square {}^*P_1$ is applied to the ultrasonic transducer.

**2.** Method according to claim 1, **characterised in that** in step c2), the value $P_1$ of the parameter is applied to the ultrasonic transducer and the value U of the amplitude of the sensor signal is obtained once a stationary condition has set in and, that in step d2) the correction factor $\square$ is determined as $\square = U_{Ref}/U$.

**3.** Method according to claim 1, **characterised in that** in step c2), the value of the parameter P is changed until the amplitude of the sensor signal assumes the value $U_{Ref}$ and, that the correction factor $\square$ is determined as $\square = P_2/P_1$.

**4.** Method according to any of claims 1 to 3, **characterised in that** the capillary (10) is placed on several locations on the contact area (9) of the sensor (1) and that the reference value $U_{Ref}$ and the correction factor Dare determined based on the measured values obtained at these locations.

**5.** Method according to any of claims 1 to 4, **characterised in that** the parameter P is the alternating current which flows through the ultrasonic transducer.

**6.** Method according to any of claims 1 to 5, **characterised in that** the sensor (1) contains piezoresistive elements (2, 3, 4, 5).

**7.** Method according to claim 6, **characterised in that** the sensor (1) contains first piezoresistive elements (2, 3, 4, 5) for measuring the shear force induced in a first direction and second piezoresistive elements (11, 12, 13, 14) for measuring the shear force induced in a second direction and that the signals delivered by the first piezoresistive elements and the second piezoresistive elements are used for determining the reference value $U_{Ref}$ and the correction factor $\square$.

## Revendications

**1.** Procédé pour le calibrage d'une ou de plusieurs machine de liaisons par fil au moyen d'un capteur (1) intégré dans une puce à semi-conducteur; chaque machine de liaisons par fil présentant une capillaire (10) tendue sur une corne; un émetteur d'ultrasons appliquant des ultrasons à la corne; l'émetteur d'ultrasons étant guidé au moyen d'un paramètre P, où une grandeur de référence $U_{ref}$ est déterminée selon les étapes suivantes au moyen d'une première machine de liaisons par fil:

a1) poser le capillaire (10), sans fil, respectivement sans boule filaire sur une zone de contact (9) du capteur (1),

b1) application d'une force de liaison $F_C$ si grande au capillaire (10) que le capillaire (10) ne glisse pas dans un mouvement de va et vient à la prochaine étape sur la zone de contact (9) du capteur,

c1) application à l'émetteur d'ultrasons d'une valeur $P_1$ prédéterminée du paramètre et détermination de la valeur $U_1$ de l'amplitude du signal capteur après qu'un état stationnaire s'est installé, et

d1) stockage de la valeur $U_1$ du signal capteur en tant que grandeur de référence $U_{ref}$,

et où le paramètre P de la première machine de liaisons par fil, par exemple après un échange de capillaires se trouve de nouveau calibré ou que le paramètre P d'une autre machine de liaisons par fil se trouve calibré pour faire fonctionner l'émetteur d'ultrasons de ladite machine de liaisons par fil avec une valeur $P_2 = \square {}^*P_1$ du paramètre P; où $\square$ est un facteur de correction qui est déterminé selon les étapes suivantes:

a2) pose du capillaire sans fil, respectivement sans boule filaire sur la zone de contact (9) du même capteur (1) ou d'un autre capteur (1) du même type,

b2) application d'une force de liaison $F_C$ au capillaire (10), et

c2) alimentation de l'émetteur d'ultrasons, et

d2) détermination du facteur de correction $\square$ de manière à ce que l'amplitude du signal capteur prenne la valeur $U_{Ref}$ lorsqu'on applique à l'émetteur d'ultrasons la valeur $P_2 = \square {}^*P_1$.

2. Procédé selon la revendication 1, **caractérisé en ce que** dans l'étape c2) on applique la valeur $P_1$ du paramètre à l'émetteur d'ultrasons et que l'on détecte la valeur U de l'amplitude du signal capteur après l'installation d'un état stationnaire, et **en ce que** dans l'étape d2) le facteur de correction □est déterminé selon □= $U_{Ref}$/U.

3. Procédé selon la revendication 1, **caractérisé en ce que** dans l'étape c2) la valeur du paramètre P est modifiée jusqu'à ce que l'amplitude du signal capteur prenne la valeur $U_{Ref}$ et **en ce que** le facteur de correction □est déterminé selon □=$P_2$/$P_1$.

4. Procédé selon une des revendications 1 à 3, **caractérisé en ce que** le capillaire (10) est posé sur plusieurs endroits sur la zone de contact (9) du capteur (1) et **en ce que** la grandeur de référence $U_{Ref}$ et le facteur de correction □sont déterminés du fait des valeurs de mesure obtenues à ces endroits.

5. Procédé selon une des revendications 1 à 4, **caractérisé en ce que** le paramètre P est le courant alternatif s'écoulant à travers l'émetteur d'ultrasons.

6. Procédé selon une des revendications 1 à 5, **caractérisé en ce que** le capteur (1) comprend des éléments piézorésistifs (2, 3, 4, 5).

7. Procédé selon la revendication 6, **caractérisé en ce que** le capteur (1) comprend des premiers éléments (2, 3, 4, 5) piézorésitifs pour mesurer la force de cisaillement induite dans une première direction et des deuxièmes éléments (11, 12, 13, 14) piézorésitifs pour mesurer la force de cisaillement induite dans une deuxième direction et **en ce que** les signaux fournis par les premiers éléments piézorésitifs et ceux transmis par les deuxièmes éléments piézorésitifs sont utilisés pour la détermination de la grandeur de référence $U_{Ref}$ et du facteur de correction □

Fig. 1

Fig. 2

Fig. 3

Fig. 4

Fig. 5

Fig. 6